# EUROPEAN PATENT APPLICATION

(11) **EP 0 697 806 A1**
(43) Date of publication of application: **21.02.1996**
(21) Application number: 95305519.1
(22) Date of filing: 08.08.1995
(51) Int. Cl.: H05K 5/02, H05K 7/14

(54) **Thermally bonded memory card holder**

(30) Priority: 19.08.1994 US 292913
(71) Applicant: THE WHITAKER CORPORATION, Wilmington, Delaware 19808 (US)
(72) Inventor: Simmons, Randy Gray, Lewisville, North Carolina 27023 (US)
(74) Representative: Warren, Keith Stanley

(57) **Abstract**

A memory card holder (10) in which the contained memory card (20) may include along an edge thereof means (22) for electrical connection to an interfacing connector. The holder (10) comprises a dielectric, peripheral frame member (30,34) having a shoulder for receiving the memory card (20) and a first and second metal cover members (14,16) arranged to be placed over the frame member. The cover members (14,16) are positioned to interfit to provide structural integrity to and shielding for the memory card (20)

The first cover member (16) has an inner planar surface in close proximity to the memory card (20) and that the surface includes a torsion resistant, strengthening member (21) bonded thereto, preferably a thin film of a thermally activated polyester polymer. In a preferred embodiment, the film is about 4.0 mils in thickness, and is bonded to the cover member by the application of heat and pressure, typically for a time of about 10 seconds at 300° F.

## Description

This invention relates to a memory card holder, where such memory card holder includes a thermally bonded stiffener member that significantly reduces or eliminates torsional stresses that may be applied to said card holder.

With the advent of sophisticated computers, facsimile machines, printers, and other computer-related electronics equipment, the need for an external printed circuit (PC) interface to be used by the computer and computer-related equipment is ever increasing. To this end, PC cards containing external memory and data to be used in computer processes have been designed. At the present time, there are three different PC card types, as defined by the Personal Computer Memory Card International Association (PCMIA). This is the standards body responsible for developing the 68-pin PC card standard. The three PC card types, are as follows:
a. Type I PC Cards are the same width and length as a common credit card, 54mm x 85.6mm, but are thicker than a credit card. The thickness of a Type I card is 3.3mm (.130'').
b. Type II PC Cards are used by those companies which are utilizing memory components that are too high to be housed within a Type I card. Type II memory cards are also the same overall length and width as credit cards, but have raised body cross section in the substrate area which gives them an overall thickness of 5mm (.195''). The raised substrate areas of these cards are 48mm in width.
c. Type III PC Cards are the result of a recent movement sponsored by the Small Form Factor Committee (SFF) to enable 1.8'' Small Form Factor Disk Drives to be plugged into memory card connectors in small portable computer applications. Type III PC cards are the same length and width as Type I and Type II PC cards. However, Type III cards have a substrate area thickness of 10.5mm. Also, Type III PC cards require a card guide opening width of 51mm of the header connector to accommodate the slightly raised substrate area.

Memory card holder assemblies may comprise a printed circuit board, a casing or frame made of an insulting material for receiving the printed circuit board, metal shielding covers, and at least one connector, typically referred to an "I/O" connector. The connector is provided on one end of the casing or frame for interfacing the memory card, and particularly the printed circuit board contained in the casing, to the computer equipment to which the card is mated. The connector is designed to extract the contents of the memory stored on the printed circuit board and to bus data to and from an outside environment, which also usually comprises a computer or other electronic equipment. In this fashion, data traverses the interface between the PC card and the outside environment so that the data can be efficiently transferred and used by the computer to which the card is mated for its intended purpose.

PC cards are generally interchangeable and can be used with many different machines and electronic components. Because the PC cards are interchangeable, they undergo a significant amount of abuse when transported, interfaced and mated to the different computers and electronic equipment which use them. Since a PC card is conventionally made up of a number of layers and/or elements glued or otherwise bonded together, the individual layers tend to become loose and/or separated from one another as the memory card is subject to flexing or torsional stresses, as may occur when the card is inserted into or removed from the electronic or other computer-type equipment. Thus, even after moderate amounts of usage, conventional memory cards have heretofore frequently become structurally loose, and the internal members of the card often become misaligned. This results in failure of the PC card and degrades the performance of the electronic equipment which uses the card. These undesirable results generally induce poor performance of the computer system which uses the memory card.

In co-pending application, S/N 08/043,316, filed April 6, 1993, now U.S. Patent No. 5,339,222, granted August 16, 1994, and assigned to the Assignee of this invention, the contents of which are incorporated herein in its entirety, there is disclosed a memory card holder that provides a good degree of structural integrity to the assembly by the use of a pair of interfitting metal sheet-like cover members. Additionally the invention thereof provides continuous shielding against distortion of data signals between the PC or memory card and the I/O connector.

The present invention represents an enhancement for the invention of U.S. Patent No. 5,339,222 by the provision of a thermally bonded stiffener member that is strategically placed to provide torsion resistance and an insulation function as hereinafter explained. The unique feature of this invention will become apparent in the description which follows, particularly when read in conjunction with the accompanying drawings.

The memory card holder of this invention comprises a dielectric, peripheral frame member having a shoulder for receiving the memory card, and first and second metal cover members arranged to be placed over the frame member. The cover members are positioned to interfit to provide structural integrity to and shielding for the memory card. The improved feature hereof is the provision of the first cover member having an inner planar surface in close proximity to the memory card, and that the surface includes a torsion resistant, strengthening member bonded thereto. Preferable the strengthening member comprises a thin film of a thermo bonding plastic, where such bonding is achieved by the application of heat and pressure.

An embodiment of the invention will now be described by way of example with reference to the accompanying drawings in which:

FIGURE 1 is an exploded perspective view of a memory card holder assembly utilizing a torsion resistant, thin film, strengthening member according to this invention.

FIGURE 2 is an exploded perspective view illustrating the pre-bonding position of the thin film, strengthening member to the underside of a first cover member.

FIGURE 3 is a perspective view of the assembled components of Figure 2.

Figure 4 is a longitudinal sectional view of Figure 3, illustrating the thin film, strengthening member bondea to the first cover member.

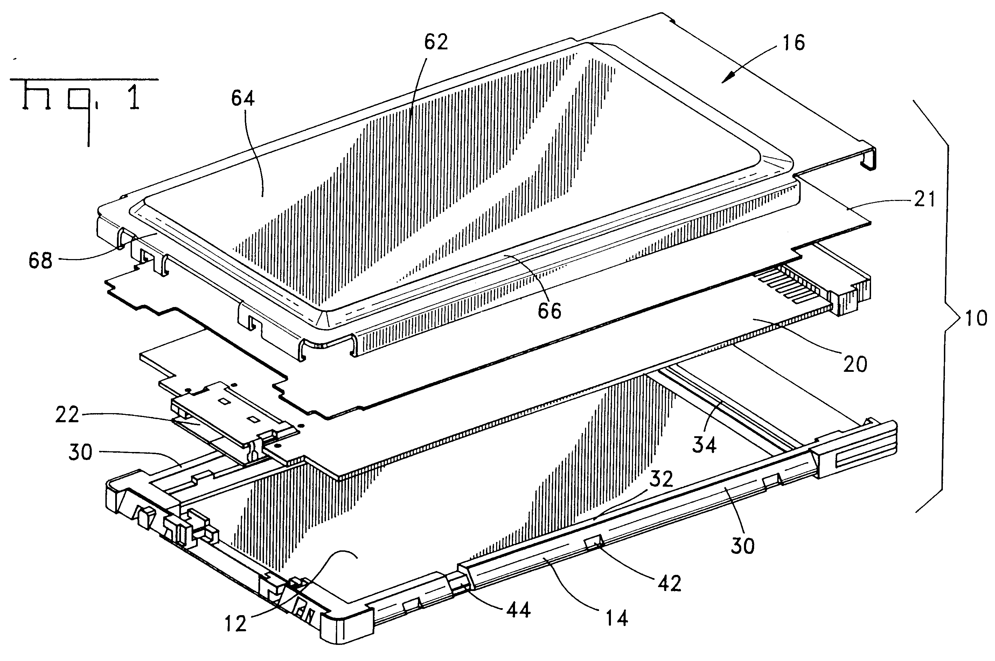

Referring now to the several Figures representing the preferred embodiment of this invention, Figure 1 illustrates an exploded view of the memory card holder 10 comprising a bottom cover member 12 of a conductive material, such as metal, preferably molded with a dielectric frame 14, and an upper cover member 16, stamped and formed of a conductive material, such as metal, where such cover members 12, 16 are adapted to receive and provide support and shielding to a memory card 20 received therebetween. Additionally, there is illustrated a torsion resistant, strengthening member 21, where said member is preferably a thin film of a thermo bonding plastic, such as a polyester polymer having a thickness of about 4.0 mils. The manner by which the member 21 is incorporated within the assembly, and its function will be detailed hereinafter.

Returning to the proposed assembly of Figure 1, a typical memory card may consist of a printed circuit board (PCB), as known in the art, or other type of planar circuit element adapted to store, receive and/or transmit data. Additionally, the memory card 20 may be provided with at least one connector as known in the art, wherein it mechanically and electrically interfaces with the memory card 20 through access port 22.

The memory card holder 10, preferably the bottom cover 12 and frame 14, which may molded together to form an integral unit, includes a pair of side rails 30 having exposed longitudinally surface portions 32. Additionally, the frame 14 may include at least one transverse member 34 to provide structural integrity to the frame and support for the memory card.

The bottom cover member 12, as illustrated in Figure 1, is essentially a planar member disposed outside the frame 14. The bottom cover member 12 may be formed at each edge to yield a peripheral shoulder portion and an upturned edge which is integrally molded into the frame 14, thereby fixing the relative position of the bottom cover member 12 to said frame 14. Reference may be made to the co-pending application for further details of the bottom cover/frame construction.

Along the side rails 30, plural spaced-apart recesses 42 may be provided to facilitate the receipt of a suitable hand tool to allow for the easy removal of the cover member 16 for replacement of the memory card 20. Additionally, a further single recess 44 may be included along one of said side rails 30 to accommodate an inturned grounding tab. Though not illustrated, reference may be made to the co-pending application to understand the function thereof.

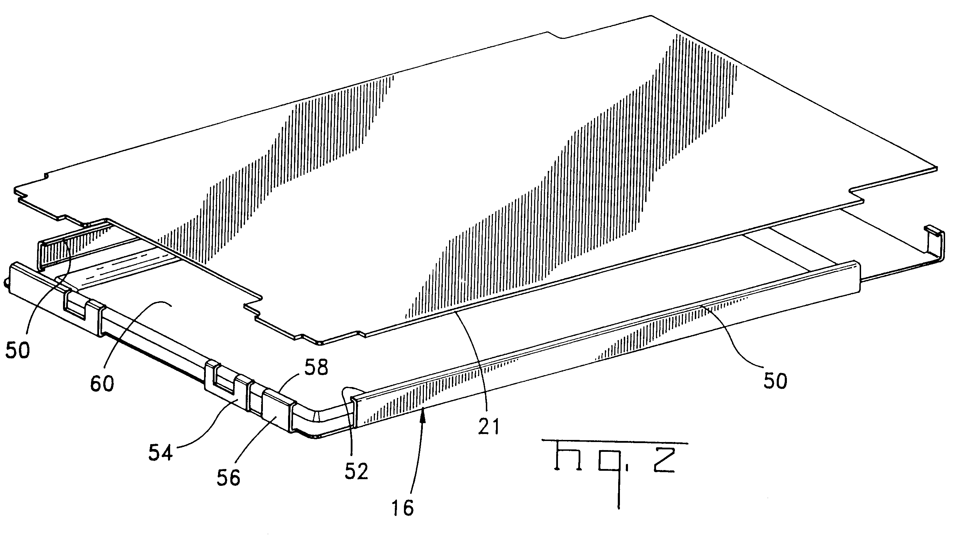

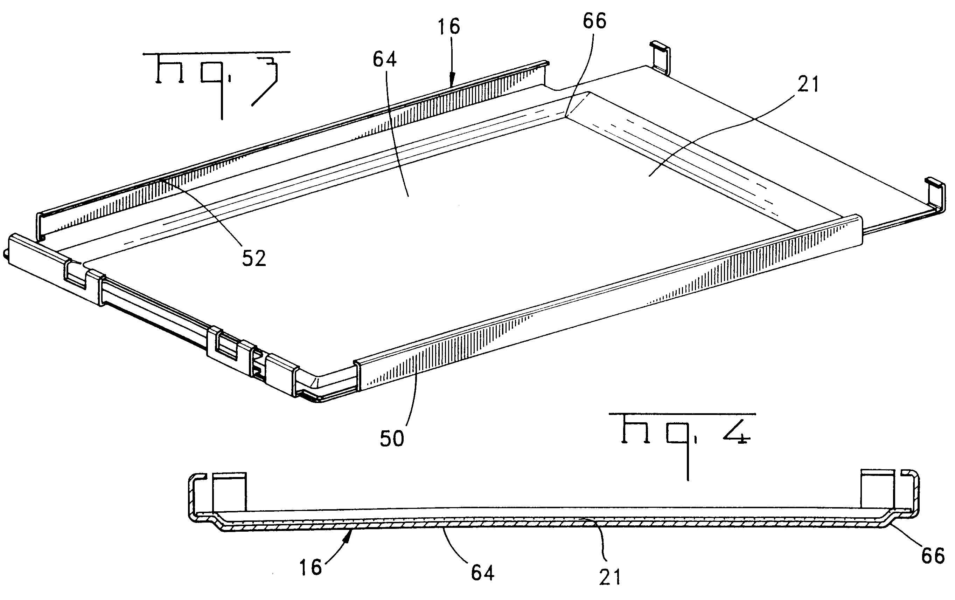

Returning now to the upper cover member 16, illustrating the underside in Figures 2 and 3, where the former Figure shows the torsion resistant, strengthening member 21 spaced from the underside of upper cover member 16. The cover member 16 is designed to be 'snap' fitted on the frame 14 in electrical contact with the bottom cover 12. The major or longitudinal sides 50 are characterized by an essentially continuous inturned flanges 52. The transverse edges 54 are discontinuous to the extent that each may accommodate a connector for engagement with the memory card 20, typically along a midpoint thereof. However, at least at the ends 56 thereof, such ends 56 further include inwardly directed flanges 58 for engagement with the frame 14.

To prepare the upper cover member 16 for use in the assembly hereof, a torsion resistant, stiffening or strengthening member 21 is bonded to the underside 60 of upper cover member 16. As viewed in Figure 1, the cover member may include a raised central portion 62 defined by a planar portion 64 and tapered side walls 66 terminating in a peripheral flanged portion 68. The strengthening member 21 is bonded to the cover member 16 along the planar portion 64, tapered side walls 66, and flanged portion 68, see Figures 3 and 4. A preferred material for the strengthening member 21 is a thin film of a thermo bonding plastic, such as a polyester polymer, about 4.0 mils in thickness. A commercial plastic sheet suitable for practicing this invention is Thermoplastic Bonding Film 614, by 3M, St. Paul, MN. The commercial product is a flexible, light colored, thermoplastic bonding film adhesive which exhibits good adhesion to a variety of substrates. It is based on polyester polymer and shows good heat and impact resistance. The bonding film construction consists of 4.0 mil adhesive coated on 3.0 mil release coated paper liner. The film product begins to soften at about 200°F, so that it can be bonded at that temperature if enough pressure is applied. There is an inverse relationship between temperature and pressure, namely, as the temperature increases, the amount of pressure may be reduced. It was discovered herein that at a temperature of 300°F, a minimal pressure, of about 10 seconds was needed to effect bonding of the strengthening member 21 to the cover member 16. However, whatever temperature is used, the manufacturer recommends that the substrates being bonded should be held together for 2 to 10 seconds to allow the adhesive to wet out the surfaces.

To assemble the memory card holder system of this invention, a thin thermobonding sheet of plastic 21, about 4.0 mils thick, is applied to the underside of a cover member 16 under the appropriate application of temperature, time and pressure to effect bonding of the plastic to the cover member 16. This not only provides a stiffening member to the assembly, but by the use of a dielectric material such as plastic, adds the dimension of insulating the cover member from the contained memory card 20. Thereafter, with the memory card positioned on the frame member 14 over the bottom cover member 12, where the surface portions 32 are exposed thereabout, the upper cover member 16 is snap fitted thereover in the manner described above. The assembly is then subjected to a further temperature/pressure step about the periphery to effect bonding of the plastic stiffening member to the frame surface portions 32. The localized heating and pressure is typically at about 300°F for 10 seconds.

## Claims

1. A holder (10) of the type for receiving a memory card (20) having means (22) along at least one edge thereof for electrical connection to an I/O connector, where the holder (10) comprises a dielectric peripheral frame member (30,34) having a shoulder (15) for receiving said memory card (10), and first and second metal cover members (14,16) arranged to the placed over said frame member, where said cover members (14,16) interfit to provide structural integrity to and shielding for said memory card (20), characterized by said first cover member (16) being removable and having an inner planar surface (64) in close proximity to said memory card (20), where said surface (64) includes a torsion resistant, strengthening member (21) bonded thereto, said strengthening member (21) comprising a thin film of a thermo bonding plastic, whereby said first cover member (16) is removable to effect a replacement of said memory card.

2. The memory card holder according to claim 1, characterized in that said shoulder (15) lies within a plane and said bonding of the thin film is to said cover (16) and said shoulder (15).

3. The memory card holder according to claim 1, characterized in that said plastic film (21) is a polyester polymer having good heat and impact resistance.

4. The memory card holder according to claim 3, characterized in that said polyester polymer film has a thickness of about 4.0 mils.

5. The memory card holder according to claim 3, characterized in that said polyester polymer is a thermally activated, bonding adhesive.

6. The memory card holder according to claim 1, characterized in that said film (21) is an insulator between said first cover member (16) and said memory card (20).
